Europäisches Patentamt

European Patent Office

Office européen des brevets

(19)

(11) Publication number: **0 078 452**
A2

# (12) EUROPEAN PATENT APPLICATION

(21) Application number: 82109686.4

(22) Date of filing: 20.10.82

(51) Int. Cl.³: **H 01 L 27/02,** H 01 L 29/20, H 03 K 19/091

(30) Priority: 02.11.81 US 317366
02.11.81 US 317367

(43) Date of publication of application: 11.05.83
Bulletin 83/19

(84) Designated Contracting States: DE FR GB NL

(71) Applicant: TEXAS INSTRUMENTS INCORPORATED,
13500 North Central Expressway, Dallas
Texas 75265 (US)

(72) Inventor: Yuan, Han-Tzong, 7131 Birchwood Drive,
Dallas Texas (US)
Inventor: McLevige, William V., 4117 Midnight Drive,
Plano Texas (US)
Inventor: Duncan, Walter M., 9604 Shoreview, Dallas
Texas (US)
Inventor: Doerbeck, Friedrich H., 7215 Azelea Lane,
Dallas Texas (US)

(74) Representative: Leiser, Gottfried, Dipl.-Ing. et al,
Patentanwälte Prinz, Bunke & Partner Ernsberger
Strasse 19, D-8000 München 60 (DE)

(54) GaAs bipolar integrated circuit devices.

(57) Integrated circuits are fabricated on a substrate 11 of
gallium arsenide using a substrate emitter device structure.
The use of gallium arsenide improves the speed of this
family of bipolar integrated circuits, because the electron
mobility of GaAs is greater than that of comparably doped
silicon. Device isolation is accomplished by implant dam-
age, increasing the circuit density. The substrate emitter
bipolar implementation provides high noise immunity and
simple layout, while power consumption is at a low level.

EP 0 078 452 A2

TITLE  0078452

BACKGROUND OF THE INVENTION

This invention relates to integrated circuits in general, and more specifically to integrated circuits fabricated with substrate emitters.

GaAs MESFET devices have been quite successful in applications such as microwave and highspeed digital circuits. This success of GaAs MESFETs has been due mainly to high electron mobility of GaAs and existence of semi-insulating GaAs substrates. Even in view of these successes, and a long period of development, the application of GaAs MESFETs to anything more than MSI logic in digital circuitry has not come about. Some of the reasons for this are: difficult circuit modeling and design, poor threshold voltage control, and sensitivity of MESFET operation to load conditions.

Silicon bipolar technology is well known for its advantages in terms of uniform threshold, noise immunity, and circuit design ease, which make it well suited for custom LSI such as gate arrays. However, the GaAs bipolar transistor has rceived little attention, due in great part to poor results obtained in the early period of research on GaAs devices. These poor results were generally caused by problems with diffusion techniques that were not accurate enough to control required device characteristics. The main problem encountered with the diffusion techniques is that dopant profile could not be adequately established in a material using diffusion. Dopant concentrations tend to fall off with depth, and the concentration at a given depth is not accurately predictable.

The difficulty with the diffusion techniques was caused by inadequate control of the doping profile of the base region. In the prior art, a zinc or magnesium diffusion would be used to form a P-type base region, but adequate control of the doping profile was not practicable. Implantation avoids this problem, since the doping profile can be controlled to be more even within the base region, as will be further discussed below. For background, see Glaser and Subak-Sharpe, Integrated Circuit Engineering (1977), which is hereby incorporated by reference.

However, recent success of ion-implantation compared to earlier diffusion techniques means that critical junction depths and doping concentrations, which significantly affect bipolar IC design and performance, can now be precisely controlled. Some problems will remain with the GaAs bipolar device, such as low hole mobility and low maximum donor concentration, but novel design of devices and circuitry should make possible the full utilization of GaAs bipolar technology potential for high-speed digital applications.

A substrate emitter bipolar technology has advantages technology. Power consumption of this family of circuitry, for example, $I^2L$, is significantly lower than standard bipolar, and packing density is greater. In comparison to MOS tehcnology, $I^2L$ has about the same packing density, but can be much faster. In spite of these advantages, $I^2L$ has shown some significant drawbacks when fabricated on a silicon substrate. Device isolation is difficult, and control of dopant levels is critical. Also, the silicon itself limits the gate delays to 10 ns or more, due to minority carrier storage characteristics of the silicon.

In order to avoid some of the problems attendant to devices with silicon substrates, the use of GaAs as a substrate has been considered. Gallium arsenide has, in particular, some useful properties in relation to the solution of the mentioned problems. The electron mobility of GaAs is known to be 6 to 7 times higher than silicon at comparable doping levels. Also, the minority carrier lifetime is very short, which solves minority carrier storage problems of silicon $I^2L$.

P-type doping in GaAs has been a serious limitation, as use of zinc diffusion for this purpose has been quite troublesome. It has now been shown that beryllium can be implanted to form P-type regions in GaAs. Use of implant methods make possible precise control of doping levels nd region depths. Also, devices in a GaAs substrate may be isolated by implant damage of the substrate. The use of a light atom, such as boron or hydrogen, will allow penetration to a depth of 1 micron or greater. Additionally, because of implant damage isolation, a planar process with higher packing density becomes possible.

It is an object of the present invention to provide an integrated circuit which has the low power consumption of prior $I^2L$ circuits, but is not limited in speed by silicon substrate material. It is a further object of this invention to provide an integrated circuit which has a high packing density and is fabricated in a planar process using implant operations.

- 4 -                    0078452

## SUMMARY OF THE INVENTION

The purpose of the present invention is to combine the advantage of silicon bipolar technology with the speed of gallium arsenide to provide a high speed, high density digital IC. Implementation of bipolar technology on a GaAs substrate using a modified form of $I^2L$ logic and a novel method of fabrication make this combination possible and practical.

One aspect of the invention is embodied in a modified version of the basic $I^2L$ logic element implanted on a substrate of GaAs. The basic $I^2L$ circuit consists of a PNP transistor load, which supplies current to an NPN transistor. The present invention replaces the PNP transistor load with a resistor load. This replacement of the PNP device is required, since the PNP device implemented on the GaAs substrate does not have the current gain required for the $I^2L$ operation.

In another IC structure of the present invention, the PNP of the standard $I^2L$ is replaced by a constant current source in the form of an N-channel MESFET device. In this configuration, the collector contacts of the NPN transistor can also be Schottky junctions, thereby further limiting the output voltage swing to approximately 400 mv.

The present invention has novel features which are decidedly advantageous over previous work done in this area. First, the use of bipolar technology to fabricate devices on a GaAs substrate makes possible high speed digital logic applications. Also, the novel modification of $I^2L$ logic to adapt it for use on GaAs combines the low power consumption and high packing density of $I^2L$ with the speed of bipolar GaAs devices. Additionally, ion implant processing, rather than diffusion, gives the accuracy required for precise junction depths and dopant concentrations. Also, because design coupling of $I^2L$ logic gates is well known in the art, as is the process for interconnection on a chip, gate array design may be reserved for an end user by fabricating a large number of basic logic gates on a chip so that design is a matter of interconnection. In this manner, typical and/or special circuit functions may be produced by addition of one or two metal levels to a chip.

In one aspect of the invention, the preferred embodiment provides novel $I^2L$-like bipolar integrated circuits on a GaAs substrate. The design of the circuits makes use of inverted (substrate emitter) transistors similar in configuration to that of $I^2L$, but having an ion-implanted velocity-saturated load resistance in place of the lateral P-N-P transistor of the $I^2L$ design. The method begins with GaAs epitaxial layers grown on a GaAs substrate by either vapor-phase epitaxy (VPE), molecular-beam epitaxy (MBE), or metal-organic chemical vapor deposition (MOCVD). The doping of the collector and base regions is done by ion-implantation, which selectively converts the GaAs into a semi-insulating material while maintaining a planar surface for subsequent processing.

In another aspect of the invention, the epitaxial layers consist of GaAs and AlGaAs. The addition of the wide band gap AlGaAs to form the emitter region enhances the performance of the device, as emitter injection efficiency is improved and a higher current gain is realized.

BRIEF DESCRIPTION OF THE DRAWINGS

Figure 1 is a schematic diagram of a preferred embodiment of the present invention.

Figure 2 is a cross-section drawing of the structure implementing the circuit of Figure 1.

Figure 3 is a schematic diagram of another preferred embodiment of the present invention.

Figure 4 is a cross-section drawing of the structure of the implementation of the circuit of Figure 3.

Figure 5 is a cross-section of a substrate and epitaxial layers before processing for device fabrication.

Figure 6 is a cross-section of the same substrate and epitaxial layers after implant for conversion to proper types.

Figure 7 illustrates the cross-section of the structure after an implant to create a P+ region.

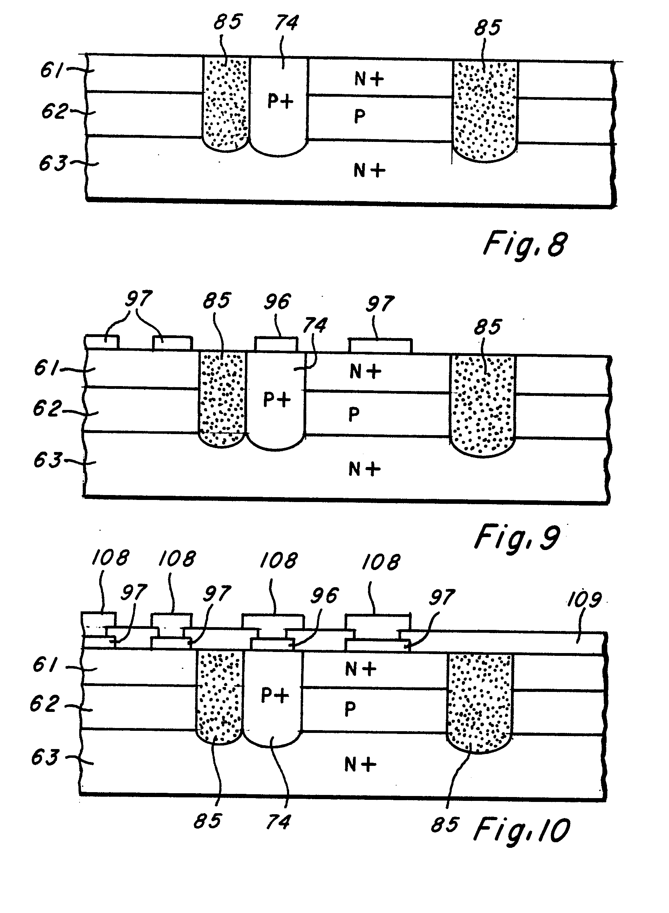

Figure 8 shows the cross-section of the structure after implant damage has created isolation regions.

Figure 9 is a cross-section of the structure showing the addition of contacts for external connections.

Figure 10 is a cross-section of a completed logic gate showing the surface passivation layer and interconnect material in place.

Figure 11 is a cross-section view of the substrate material with epitaxial layers in place over the substrate.

Figure 12 is a cross-section view of the structure after implants in the collector and base regions.

Figure 13 is a cross-section view of the structure after an implant which provides the base contact regions for the logic gate.

Figure 14 is a cross-section view of the structure after an implant to create device isolation areas.

Figure 15 is a cross-section view of the structure after contact material has been deposited.

Figure 16 is a cross-section view of the completed gate structure.

Figure 17 is a graph showing the dopant profile of the transistor device in the structure of Figure 6.

Figure 18 is a schematic diagram of the structure of Figure 6.

0078452

## DESCRIPTION OF THE PREFERRED EMBODIMENTS

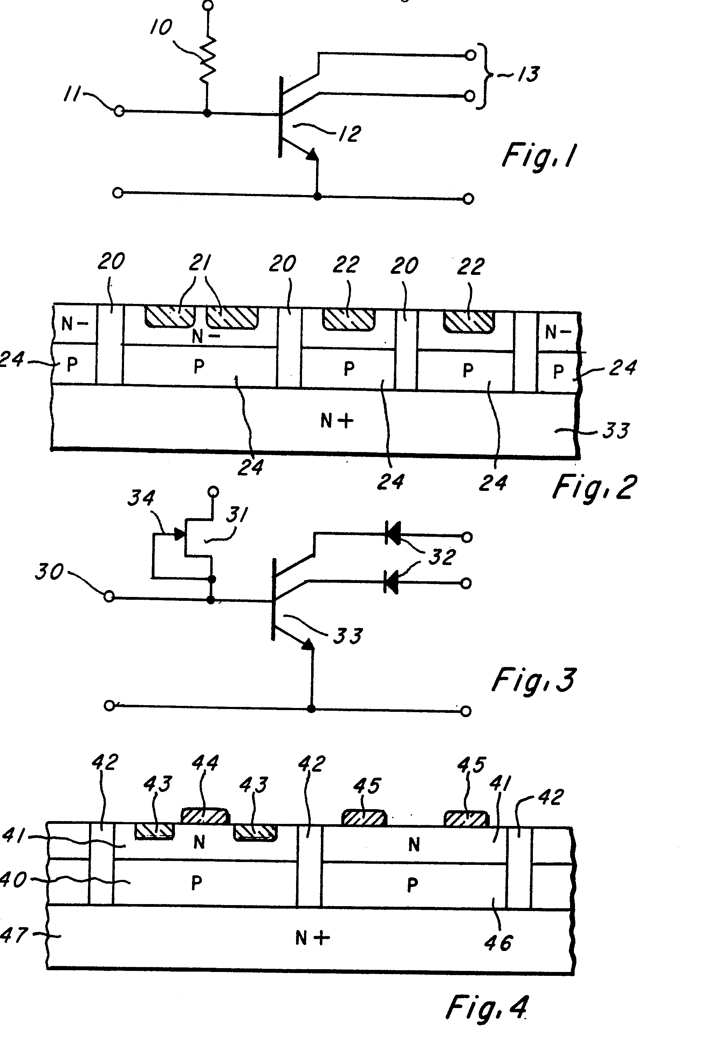

Referring now to Figure 1, there is shown a schematic diagram of a modified $I^2L$ gate circuit. The NPN transistor device 12 receives input on its base 11, and furnishes output signals on multiple collectors 13. The current injection is through current limiting resistor 10, which replaces the PNP transistor of the standard $I^2L$ circuit. This replacement is necessary because of the relative inefficiency of the PNP transistor on a GaAs substrate.

In Figure 2 there is shown a cross-sectional view of the structure of the circuit in Figure 1. The surface of N+ substrate 23 is covered by N- epitaxial layer 21. The N-epitaxial layer is subsequently implanted with a P type dopant to create a buried P type layer 24. Isolating areas 20 are formed by ion implantation damage, so that electrical activity is no longer significant in these areas.

N+ ohmic contacts 21 form the isolated current limiting resistor which provides the injection current for the gate, and collector contacts 22 are outputs for the gate.

Figure 3 is a schematic diagram of an alternative way of replacing the inefficient PNP transistor. The NPN transistor 33 receives inputs on its base 30, and current injection is handled by an MESFET 31 having a Schottky gate 34 shorted to the source of the MESFET 31, thereby providing a constant current source for the NPN transistor 33. The collector outputs 32 are Schottky junctions and therefore limit the output voltage swing to approximately 400 mv.

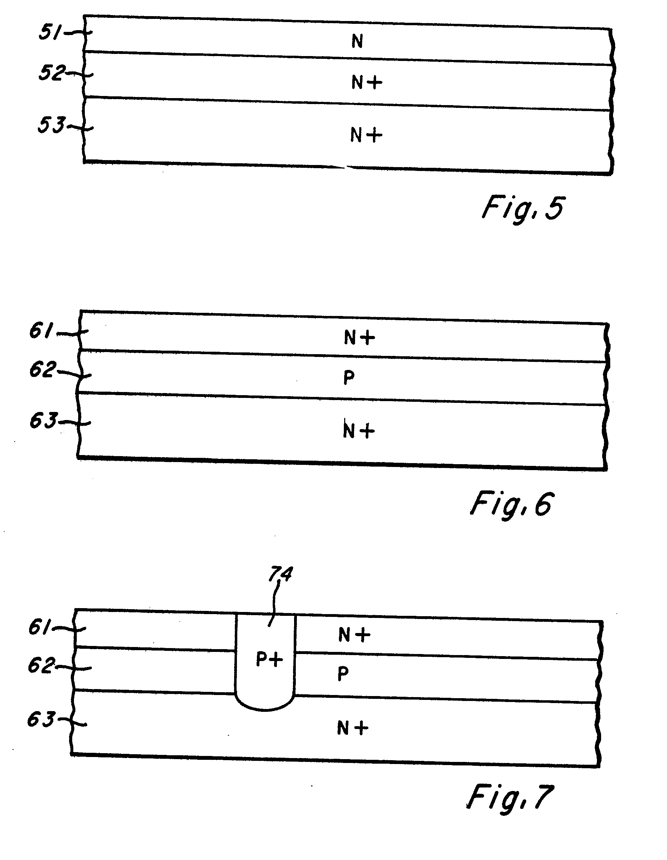

Figure 4 shows the implementation of the circuit in Figure 3 on a GaAs substrate. The N+ substrate 47 is covered by a layer of undoped epitaxial material. Next, the layer is implanted with Be to create P-type areas 40 and 46. N-type material is then diffused or implanted to form an N-type upper layer 41. Implant damage 42 is then caused to isolate each device. The constant current device is composed of N+ ohmic contacts 43 and Schottky gate 44. The Schottky collectors 45 clamp the output voltage swing to approximately 400 mv. Connections of the isolated devices are made in subsequent steps.

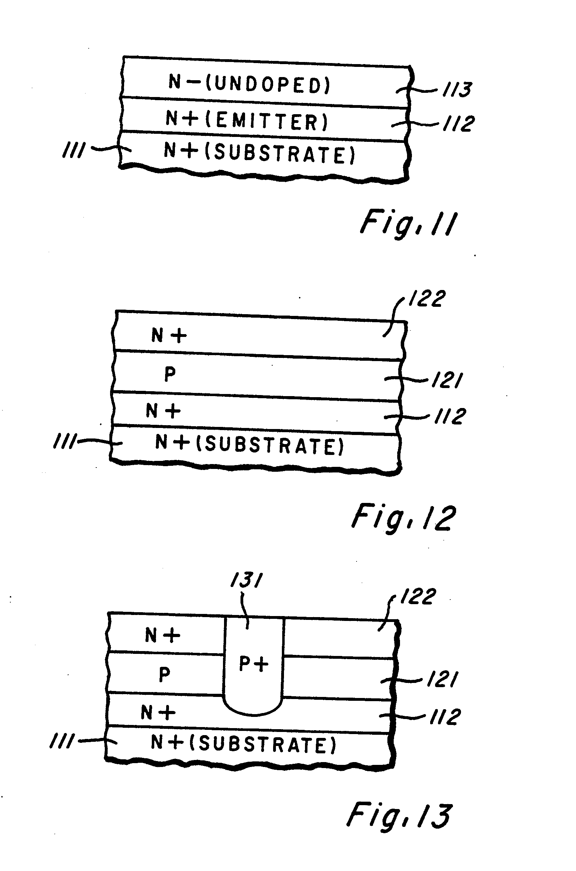

As shown in Figure 11, one embodiment of the fabrication process of the present invention begins with a structure having a substrate wafer of gallium arsenide (GaAs) 111 approximately 15 mils thick. This substrate material is doped with an appropriate donor material to make substrate heavily N-doped. This is accomplished by doping with, for example, tellurium, or silicon at a level of $10^{18}$ per $cm^3$ or greater. Next, a layer 112 of GaAs having a thickness of approximately 1.6 micron is grown by, for example, vapor phase epitaxy (VPE), over the substrate material. This layer is doped with a donor material, for example, sulfer, to a level of approximately $10^{18}$ $cm^{-3}$, making the layer highly N type. The final layer of the structure is a layer of GaAs 113 of approximately .8 micron thickness, which is undoped. Donor concentration in the undoped GaAs is approximately $10^{15}$ $cm^{-3}$ due to remnant impurities.

The first N+ epitaxial layer is not electronically necessary, but is provided due to the normal crystalline properties of easily available gallium arsenide substrate. That is, if a doped gallium arsenide substrate having a satisfactorily low defect level could be provided, the N+ substrate could itself be used as the emitter. In this alternative embodiment, only a single (undoped) epitaxial layer is grown, and the base and collector are then formed by subsequent implants as described below. In the preferred embodiment, the N+ epitaxial layer for the emitter is grown because this provides better physical characteristics at the emitter/base junction. Thus, the first N+ epitaxial layer is provided for physical rather than electronic reasons.

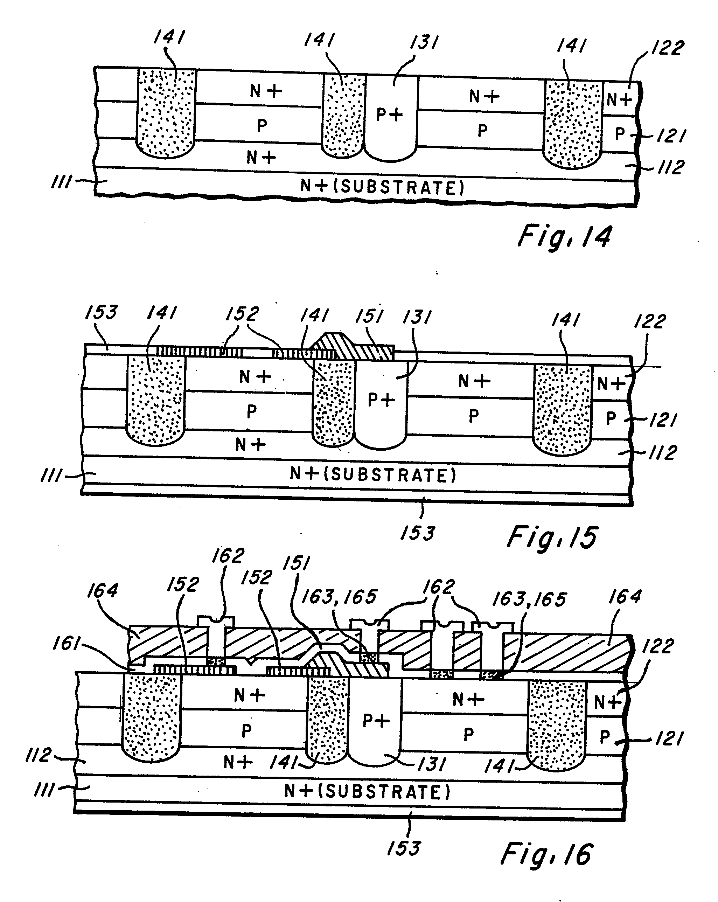

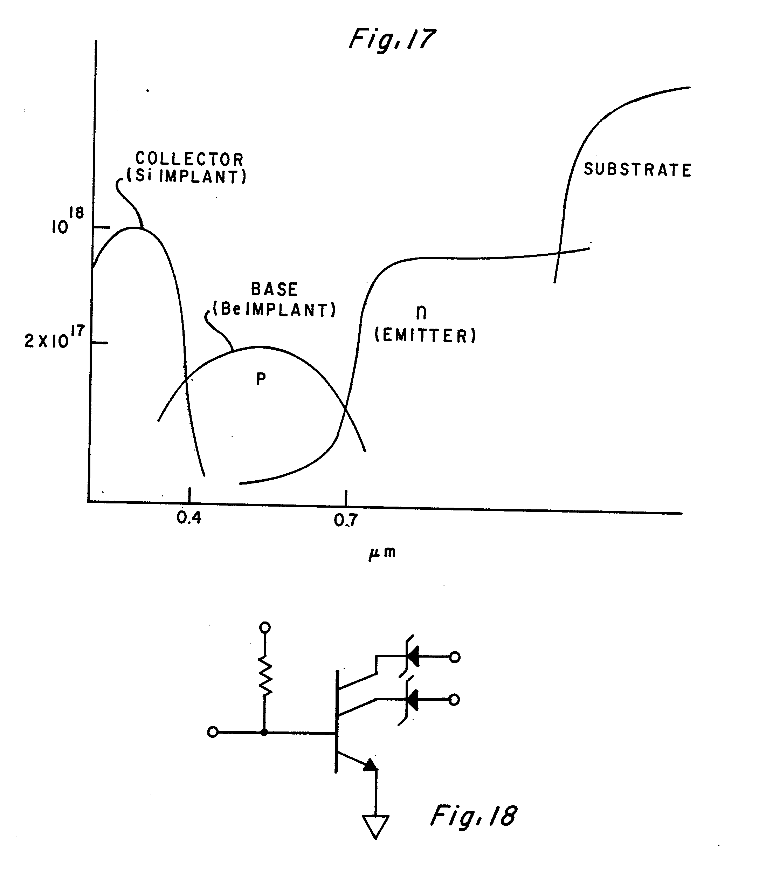

Processing of the structure continues with a first implant of, for example, a 1.5 x $10^{13}$ cm$^{-2}$ dose of, for example, silicon or selenium at 80 keV. Next, a second implant is made, for example, of a 3 x $10^{13}$ cm$^{-2}$ dose of silicon at 180 keV. The reason for implanting more than one time is to obtain a more even dopant profile. The more flat the profile curve, the more consistent the dopant througout the doped region, and more efficient and reliable device. As shown in Figure 12, this converts the upper layer of GaAs 122 to heavily doped N-type, to form the collector of the inverted transistor. In implantation processes, the dosages indicated are surface incidence dosages, and are measured in cm$^{-2}$ (inverse square centimeters). The epitaxial layers are grown from materials having a dopant concentration which is measured in cm$^{-3}$ (inverse cubic centimeters). In order to calculate the dopant level per cm$^3$ of a location after an implant, reference can be made to the appropriate tables in Projected Range Statistics, Semiconductors and Related Materials; J. F. Gibbons, W. J S. Johnson, and S. W. Mylroie, Dowden, Hutchinson, and Ross, Inc., Stroudsburg, Pa., 1975. The structure is then annealed at 850 C in an arsenic overpressure atmosphere for 15 minutes. The arsenic overpressure atmosphere is composed of a hydrogen carrier gas at 1 atmosphere and a partial pressure of arsenic vapor between 10-1 and 10-7 atmospheres. The structure is now implanted with, for example, 8 x $10^{12}$ cm$^{-2}$ of Be at 180 keV to form the base region. (Alternately Mg, Cd, or Zn may be implanted). Figure 12 shows the result of the implant, which is to create a P type region in the lower portion of the undoped N epitaxial layer 113. The structure is again annealed in an arsenic overpressure atmosphere at 850 C for 15 minutes. The implant profile of the transistor structure now is as shown in the graph of Figure 17. The collector designation in Figure 17 is made referring to an $I^2L$, or inverted transistor, structure.

Referring now to Figure 13, a patterned implant is made in two steps to form a P+ region 131 from the surface of structure down into the emitter to contact the base region. In the first step, $2 \times 10^{14}$ cm$^{-2}$ of, for example, Be is implanted at 40 keV. Then, the same material is implanted again, $3 \times 10^{14}$ cm$^{-2}$ at 80 keV. The two implants here serve a dual purpose. First, the implant profile is evened out somewhat, and secondly, a low surface resistance is provided so that the ohmic contact to the base region will be low resistance. The structure is then annealed at 700 C for 30 minutes. This low temperature anneal is used here to prevent diffusion, and to maintain a high acceptor concentration (8 to $10 \times 10^{18}$ cm$^{-3}$) to over-compensate the collector doping shown in Figure 17 (implant profile).

Now, as shown in Figure 14, an implant step is used to create isolation regions 141 to insulate devices on the structure from each other. The implant step is done in three parts. The first part is a boron implant of $2 \times 10^{12}$ cm$^{-2}$ at 50 keV. The second part is an implant of $4 \times 10^{12}$ cm$^{-2}$ of boron at 140 keV. The final implant is $6 \times 10^{12}$ cm$^{-2}$ of boron at 320 keV. These implants create isolation regions by damaging the GaAs material to the point that it becomes a semi-insulator. This effectively isolates each device on the structure and provides a planar surface for subsequent processing. This implant serves to create isolation, because the lattice damage created is such that the resistivity of

0078452

the material is raised to a very high level. To successively accomplish this technique of isolation implanting, there are four conditions which must be met: (1) The implanted species should preferably be a light ion, so that the implantation can reach to the depths required. (2) The species implanted should preferably be a non-doping species. In gallium arsenide, hydrogen and boron are suitable for this. (3) The dosages used should be sufficient to damage the lattice everywhere within the desired isolation region, to the point where a high resistivity is achieved. To accomplish this, multiple implants may be used, as in the presently preferred embodiment just discussed. (4) Subsequent high-temperature steps should be avoided, to prevent annealing of the lattice and lowering the resistivity by healing of the lattice damage. In the presently preferred embodiment, steps above 600 C are avoided after the isolation implant. Some higher-temperature processing could be performed, since the degree of isolation presently achieved is more than sufficient. Thus, in addition to providing a planar surface above the isolation regions, compact isolation is achieved with minimal waste of real estate. A major advantage which this method of isolation provides is that oversize contacts can be used, i.e., contact metallization can run right over isolation regions (and hence as a first level of interconnects), and no step coverage problem occurs since the isolation regions are themselves planar.

The resulting dopant levels in the implanted regions, and the thickness of these layers for the homojunction transistor should be within the following values:

In the emitter region, from $2 \times 10^{17}$ to $2 \times 10^{18}$ $cm^{-3}$ (thickness of 2-10 micron) (N type); in the base region, from $5 \times 10^{16}$ to $5 \times 10^{17}$ $cm^{-3}$ with a thickness of .1 to .6 micron (P type) and in the collector region, from $5 \times 10^{16}$ to $5 \times 10^{18}$ $cm^{-3}$ (N type) with a thickness of .2 to .6 micron. Particularly, the doping level of the emitter should be at least 5 times greater than the dopant level of the base, and preferably more than 10 times greater.

Figure 15 shows the structure after having ohmic contact 151 deposited on the surface of the structure by methods well known to those skilled in the art. A layer of silicon nitride is deposited on the GaAs surface before the photo-resist pattern is applied and developed, so that silicon-nitride assisted lift-off can be accomplished. This step assures a sharp definition of the ohmic contact shapes. After the contacts are deposited, the silicon nitride is removed. The P type ohmic contact 151 is, for example, a silver/manganese alloy having a thickness of approximately 2000 A. The alloy ratio of the metal is approximately 92% silver, 8% manganese. N type ohmic contacts 152 are a gold/germanium alloy, (88% gold, 12% germanium) covered by nickel, having a total thickness of 1500 A. The nickel thickness should be about 25% of the thickness of the gold/germanium. The same metal compound is evaporated all over the back side of the subtrate to form the substrate/emitter contact 53. The structure is then subjected to a temperature of 430 C for 1 minute to alloy the ohmic contacts.

The N type ohmic contacts 152 define by their geometric relationship the velocity saturation load for current injection to the base of the logic gate. The distance between these contact regions determines the turn-on voltage, i.e. the voltage to attain saturation current. This distance may

- 14 -                                    0078452

be approximately 1 micron. For cases where the turn-on voltage may be high enough to cause "punchthrough" of the relatively thin base layer (.1-.6 micron) to the emitter layer, an added P type implant in the area underneath the velocity saturation load in the base region to increase the dopant concentration to $10^{18}-10^{19}$ per cc may be necessary for reliable operation.

In the presently preferred embodiment, a drift space of two microns between the two ohmic contacts is used for velocity-saturated load. With these dimensions, a turn-on voltage of about 1½ volts is attained. In addition, by regulating the width of the region across which drift between the ohmic contacts occurs, the current provided at saturation can be independently regulated. In particular, the current limited by the velocity-saturated load can be fine-tuned at a very late stage of fabrication, by a damaging implant, e.g., boron, as discussed above, which is applied to a portion of the drift space between the ohmic contacts. Thus, the dimensions of the velocity-saturated load are regulated, first, so that punch through to the emitter region does not occur, second, to select the volts per centimeter witinin the drift region at the desired operating voltage of the circuit, and third, to regulate the current at saturation. Thus, the following advantages are provided by the velocity-saturated load: (1) No added process complexity is introduced. (2) Turn-on of the load element occurs at a very low voltage, since adjustment of the dimensions of the velocity-saturated load can easily be performed to regulate the turn-on voltage to approximately one volt. This compares very favorably with polysilicon load resistors, or MOS depletion loads, although it is not as good as that attained with PNP transistors. (3) The characteristics of the load are relatively insensitive to process parameters. (4) The characteristics of the load can be fine-tuned if necessary at a very late stage of processing. (5) Perhaps the most important advantage of the velocity-saturated load is that an exceedingly small load element is attained, so that an extremely high packing density may be achieved. The advantages of a velocity-saturated load in gallium arsenide, using spaced contacts as described above, may also be applied to other families of current-mode logic in gallium arsenide.

In the presently preferred best mode of practicing the invention, the final step has two parts. First, as shown in Figure 16, a layer of insulating material 161, for example, silicon nitride, is grown over all the top surface to a thickness of approximately 800 A. Next, a layer of polyimide 164 is deposited over the silicon nitride to a thickness of 0.7 to 1.5 micron. These layers passivate the surface and insulate the metal interconnects from the device. Windows are then etched through the polyimide and silicon nitride to the contacts and the device surface. The second part of the step deposits a 1000 A layer of Titanium 163 on the uncovered surface of ohmic contacts, an intermediate layer of 500 A of platinum 165, then a 6000 A layer of gold 162 over the platinum. The deposition of the interconnect titanium/platinum/gold layer over the insulator minimizes the bonding pad capacitance. In addition to forming the interconnect function, the titanium/platinum/gold serves as the Schottky metal for the Schottky-barrier fan out isolation diodes.

The provision of fan out isolation diodes provides major advantages. First, such Schottky-barrier fan out isolation diodes have approximately a 4:1 area advantage over junction fan out isolation. Second, the provision of the fan out isolation diodes directly on top of the collector layer in the present invention means that there is no significant voltage drop limitation in adding a large number of fan out isolation diodes, since all fan out isolation diodes are separated from the emitter only by the thickness of the base and collector layers. Third, provision of Schottky-barrier fan out isolation diodes according to the present invention does not add significant processing complexity, since these diodes are (in effect) self-aligned structures. Thus, in the present invention, the fan out is limited only by the current gain of the switching transistor. This is a particular advantage in the heterojunction embodiment, since the very large gain possible in the transistor of that embodiment (as will be described below) permits huge fan out capability, comparable to that of MOS. The characteristics of the velocity-saturated load element do not limit fan out, since the saturation current of that load element can be selected to be as large as desired, merely by increasing the width of the drift space, as discussed above. While Schottky-barrier diodes are used for fan out isolation in STL, STL fan out is limited by the voltage drop which occurs across the lateral collector structure. This voltage drop means that the required noise margin limits available fan out. Alternatively, junction-diode fan out isolation could be used, although this is not the preferred embodiment of the invention.

Figure 18 shows a schematic diagram of the basic logic gate of the present invention. Note that Schottky fan out isolation diodes are shown, according to the presently preferred embodiment.

A schematic diagram of the basic logic gate of the fabrication process disclosed is shown in Figure 18.

The present invention has heretofore been described with reference to an embodiment using homojunctions. However, significant further advantages are attained using a heterojunction structure. Although at present, the heterojunction structure is much less economical to fabricate, the performance advantages have now been verified, and both homojunction and heterojunction embodiments are within the scope of the present invention.

In a preferred embodiment of the present invention, there is provided a heterojunction structure upon which devices are fabricated. The substrate of this structure is identical to the substrate of the homojunction structure. The layers over the substrate are grown either by the molecular-beam epitaxy method or the metal-organic chemical vapor deposition method.

In the heterojunction embodiment, an $Al_xGa_{1-x}As$ emitter is used with X preferably in the range of 0.05 to 0.10, although larger percentages of aluminum could also be used. Processing difficulty is increased significantly as a larger percentage of aluminum is introduced into an AlGlAs alloy, and the advantages of the present invention are adequately attained by use of a 10% substitution of aluminum. A 10% substitution of aluminum causes a 100 meV increase in the bandgap, but this small increase is sufficient to radically improve device performance. This is because        for such gallium arsenide structures is typically 25 meV. Thus, the 100 meV of increased bandgap causes a unilateral injection preference  of approximately $e^4$ (approximately 50). This causes a significant increase in the emitter efficiency, and thus a much higher gain through the transistor is achieved. If a higher percentage of aluminum is used, no further effective improvement in gain is realized, and other effects (which may be adverse) begin to dominate. The doping levels used in the heterojunction embodiment are also changed, since the emitter and base doping levels are now preferably approximately equal. Since the bandgap difference provides injection efficiency at the emitter/base/junction, the heavier doping normally used for the emitter is not required. In fact, too heavy emitter doping levels produce a decreased effective bandgap, so that reduced gain is produced by excessive emitter doping of the heterojunction device.

The first layer is preferably an N+ GaAs buffer layer having a thickness of (e.g.) 0.2 micron doped at the same level as the substrate. At this point, an additional layer is introduced. This layer is an AlGaAs layer with a composition of 5-20% Al, approximately 2 micron thick. This wide band-gap material significantly increases the current gain of the devices fabricated on this structure. As in the alternative embodiment, the upper layer is N type lightly doped GaAs 0.8 micron thick. The processing of this beginning material is identical to that of the previously described structure . The resulting dopant levels, and the thickness of the levels, of the heterojunction device are as follows:

in the AlGaAs emitter region $1x10^{16}$ to $5x10^{18}$ $cm^{-3}$ with a thickness of 0.2 to 5 micron (N type), in the base region, $5x10^{16}$ to $1x10^{19}$ $cm^{-3}$ with a thickness of 0.1 to 0.6 micron (P type); in the collector region, $5x10^{16}$ to $5x10^{18}$ $cm^{-3}$ with a thickness of 0.2 to 1 micron (N type). In this embodiment, the emitter-base doping ratio is less critical. This is an advantage, as doping levels can then be optimized so that the base sheet resistance can be minimized, along with the emitter junction capacitance, because the current gain of the heterojunction device is relatively insensitive to the emitter-base doping ratio.

After fabrication of inverted transistor (buried emitter) test devices, the tests have shown that heterojunction devices of this type typically have a current gain of approximately 100, while the current gain of the homojunction devices of this type is between 2 and 7, typically.

The method of fabrication as disclosed in the present invention is a significant advance in the art of high speed digital circuitry fabrication. The use of GaAs provides a basic advantage over other semiconductors, in that its characteristics allow for a great improvement in speed. Gate delays of 0.5 ns are well within reason. Additionally, the implementation of a novel modified $I^2L$ technology in bipolar devices represents advantages such as noise immunity, circuit design ease, and high packing density.

Fabrication of bipolar high speed digital circuits on GaAs is a novel combination of materials and processes to produce an integrated circuit that is more dense, faster, and easeier to use than other types of these circuits.

Claims

What is claimed is:

Claim 1. An integrated circuit device comprising:

a crystalline substrate;

an emitter layer on said substrate, said emitter layer being lattice-matched to said substrate and comprising a first III-V material and having a first conductivity type;

a base layer on said emitter layer, said base layer comprising a second III-V semiconductor material having a bandgap which is smaller than the bandgap of said first III-V semiconductor material, said base layer having a second conductivity type; and

a collector layer at the surface of said device, said collector layer being on said base layer and having said first conductivity type.

Claim 2. The device of Claim 1, wherein said collector layer comprises said second semiconductor material.

Claim 3. The device of Claim 1, further comprising:

a plurality of Schottky barrier metal contacts to said collector layer, whereby said Schottky barrier metal contacts provide fanout isolation diodes.

Claim 4. The device of Claim 3, wherein the thickness of said collector  layer is one micron or less.

Claim 5. The device of Claim 3, further comprising first and second ohmic contacts on said collector layer, said first and second ohmic contacts defining a velocity-saturated load element therebetween, said velocity-saturated load element being spaced apart from said fanout isolation diodes.

Claim 6. The device of Claim 1, further comprising an isolation region at least partially surrounding said device, said isolation region comprising lattice-damaged areas of said second semiconductor material, said isolation regions extending from the surface of said device down to said emitter layer.

Claim 7. The device of Claim 1, 2, 3, 4, 5, or 6, wherein said first semiconductor material is gallium aluminum arsenide, and said second semiconductor material is gallium arsenide.

Fig.1

Fig.2

Fig.3

Fig.4

51 — N

52 — N+

53 — N+

*Fig. 5*

61 — N+

62 — P

63 — N+

*Fig. 6*

74

61 — N+

62 — P+    P

63 — N+

*Fig. 7*

**Fig. 8**

**Fig. 9**

**Fig. 10**

| N-(UNDOPED) | 113 |
| N+(EMITTER) | 112 |
| N+(SUBSTRATE) 111 | |

Fig. 11

| 122 |
| N+ | |
| P | 121 |
| N+ | 112 |
| N+(SUBSTRATE) 111 | |

Fig. 12

| 131 | 122 |
| N+ | P+ |
| P | 121 |
| N+ | 112 |
| N+(SUBSTRATE) 111 | |

Fig. 13

Fig. 14

Fig. 15

Fig. 16

Fig. 17

COLLECTOR
(Si IMPLANT)

SUBSTRATE

$10^{18}$

BASE
(Be IMPLANT)

$2 \times 10^{17}$

n
(EMITTER)

P

0.4

0.7

$\mu m$

Fig. 18